# EUROPÄISCHE PATENTSCHRIFT

(11) **EP 1 848 049 B1**
(45) Veröffentlichungstag und Bekanntmachung des Hinweises auf die Patenterteilung: **09.12.2009**
(21) Anmeldenummer: 06009302.8
(22) Anmeldetag: 05.05.2006
(51) Int. Cl.: H01L 51/50, H01L 51/54

(54) **Lichtemittierendes Bauelement**
Light emitting device
Dispositif d'émission de lumière

(30) Priorität: 19.04.2006 EP 06008082
(43) Veröffentlichungstag der Anmeldung: 24.10.2007
(73) Patentinhaber: Novaled AG, 01307 Dresden (DE)
(72) Erfinder: Birnstock, Jan, 01187 Dresden (DE); Blochwitz-Nimoth, Jan, 01097 Dresden (DE)
(74) Vertreter: Bittner, Thomas L.

(56) Entgegenhaltungen:
- EP-A- 1 511 094
- EP-A- 1 806 795
- WO-A-2005/086251
- COTTON F A ET AL: "Closed-shell molecules that ionize more readily than cesium" SCIENCE, AMERICAN ASSOCIATION FOR THE ADVANCEMENT OF SCIENCE,, US, Bd. 298, Nr. 5600, 6. Dezember 2002 (2002-12-06), Seiten 1971-1974, XP002330163 ISSN: 0036-8075
- HE GUFENG ET AL: 'Very high-efficiency and low voltage phosphorescent light-emitting diodes based on a p-i-n junction' JOURNAL APPLIED PHYSICS Bd. 95, Nr. 10, 15 Mai 2004, Seite 5773, XP012066648
- NORBERT KOCH ET AL: 'Optimized Hole Injection with Strong Electron Acceptors at Organic-Metal Interfaces' PHYSICAL REVIEW LETTERS Bd. 95, 30 November 2005, Seite 237601, XP002444523

## Beschreibung

Die Erfindung betrifft ein lichtemittierendes Bauelement, insbesondere Leuchtdiode, mit einer Anordnung von Schichten auf einem Substrat, wobei die Anordnung von Schichten einen Anodenkontakt und einen Kathodenkontakt sowie einen zwischen dem Anodenkontakt und dem Kathodenkontakt angeordneten, lichtemittierenden Schichtstapel mit einer polymeren Schicht aus einem Polymermaterial und einer niedermolekularen Schicht mit im Vakuum aufgebrachten kleinen Molekülen eines organischen Materials umfaßt.

### Hintergrund der Erfindung

Organische Leuchtdioden sind seit der Demonstration niedriger Arbeitsspannungen (vgl. Tang et al., Appl. Phys. Lett. 51 (12), 913 (1987)) aussichtsreiche Kandidaten für die Realisierung großflächiger Displays und anderer Anwendungen, wie zum Beispiel Beleuchtungselemente. Sie umfassen eine Anordnung dünner Schichten aus organischen Materialien. Die Schichten werden entweder bevorzugt im Vakuum in Form von Molekülen aufgedampft. Auf diese Weise werden niedermolekulare Schichten gebildet. Eine organische Leuchtdiode auf Basis derart gebildeter niedermolekularer Schichten aus mittels Vakuumverdampfung abscheidbaren Molekülen wird verkürzt auch als OLED bezeichnet. Es wird in diesem Zusammenhang auch von dem *"small molecule"*-Technologiebereich gesprochen.

Alternativ werden die Schichten aus organischen Materialien aus Polymermaterialien gebildet, die aus einer Lösung aufgeschleudert, gedruckt oder in anderer geeigneter Form aufgebracht werden, so dass polymere (organische) Schichten entstehen. Eine organische Leuchtdiode auf Basis derart gebildeter polymerer Schichten wird verkürzt auch als PLED bezeichnet.

Durch die Injektion von Ladungsträgern, nämlich von Elektronen und Löcher, aus den Elektrodenkontakten in die dazwischen angeordneten organischen Schichten beim Anlegen einer äußeren Spannung an die Elektrodenkontakte, der folgenden Bildung von Exzitonen (Elektron-Loch-Paaren) in einem aktiven licht emittierenden Bereich (Emissionszone) innerhalb der organischen Schichten und der strahlenden Rekombination der Exzitonen wird Licht erzeugt und von dem Bauelement emittiert.

Üblicher Weise liegt organischen Leuchtdioden mit einem PLED-Aufbau folgende Schichtstruktur zugrunde: (1) Trägersubstrat (transparent, zum Beispiel aus Glas); (2) Anodenkontakt (transparent, meistens aus Indium-Zinn-Oxid (ITO)); (3) Löchertransport- oder Löcherinjektionsschicht (zum Beispiel aus PEDOT:PSS oder PANI - Polyanilin mit Beimischungen wie PSS; PEDOT = Polyethylenedioxythiophene, PSS = Polystyrenesulfonate); (4) polymere Schicht als lichtemittierender Bereich aus einem Polymermaterial (zum Beispiel MEH-PPV, Polyfluorene, andere PPVs, Polyspiros, Polythiophene oder Polyparaphenylene) und (5) Kathodenkontakt (zum Beispiel aus einem Metall mit niedriger Austrittsarbeit wie Barium, Calcium).

Die polymeren Schichten, nämlich die Löchertransport- oder Löcherinjektionsschicht und der lichtemittierende Bereich werden aus einer flüssigen Lösung, zum Beispiel in Wasser oder in Lösungsmitteln, hergestellt. Die Elektrodenkontakte (Anoden- und Kathodenkontakt) werden typischerweise mittels Vakuumprozessen erzeugt.

Die Vorteile dieser Struktur einer organischen Leuchtdiode für Anwendungen, zum Beispiel Displays, ist die Vielfältigkeit der Prozesse zum Ausbilden der polymeren Schichten. Darunter befinden sich solche Prozesse, die eine einfache laterale Strukturierung der PLED erlauben, nämlich das Tintenstrahl-Drucken (Ink-Jet-Drucken). Bei diesem Verfahren werden die unterschiedlichen Polymermaterialien auf vorher vorbereitete Stellen gedruckt, wodurch nebeneinander liegende Bereiche verschiedener Emissionsfarbe entstehen können. Andere Methoden zur Strukturierung schließen den Siebdruck ein.

Nachteil der bekannten PLED-Strukturen ist unter anderem, dass in geeigneter Weise nicht mehr als zwei verschiedene polymere Schichten aufgetragen werden können, da die Lösungsmittel der Polymermaterialien so gewählt werden müssen, dass sie sich gegenseitig nicht beeinflussen, das heißt das Material der Unterlage nicht angreifen. Dieses bedeutet, dass das aufgetragene Polymermaterial gleichzeitig auch gut zum Elektronentransport und zur Elektroneninjektion aus dem Kathodenkontakt geeignet sein muss, eine Forderung, die eine starke Einschränkung für die Materialauswahl und die Strukturoptimierung darstellt. Neuere Untersuchungen ergaben, dass auch dreilagige Strukturen realisierbar sind.

Hinzu kommt, dass die Reihenfolge der Struktur für ein gegebenes Materialsystem nur schwer geändert werden kann. Es ist also, wie oben beschrieben, mit dem Anodenkontakt zu beginnen. Dies ist insbesondere für die Integration der PLED-Struktur auf Aktiv-Matrix Display-Substraten mit n-Kanal-Transistoren als Schaltelement nachteilig. Die Verwendung transparenter Deckkontakte ist ebenso schwierig, da diese (i) eine für die Elektroneninjektion ungünstige Austrittsarbeit aufweisen (Austrittsarbeit ist zu groß) und (ii) meistens durch einen Sputterprozess hergestellt werden. Dieser Prozess zerstört aber organische Materialien. Da die oberste Schicht in einer PLED eine lichtemittierende Schicht ist, wird die Effizienz der Lichterzeugung der organischen Leuchtdiode dadurch gesenkt. Zur Verbesserung der Stabilität gegen Sputterschäden wurde das Einbringen einer im Vakuum aufgedampften niedermolekularen organischen Schicht aus kleinen Molekülen vorgesehen. Allerdings stellt auch in diesem Fall die Elektroneninjektion aus dem Kathodenkontakt ein Problem dar.

Ein weiterer Nachteil der üblichen PLED-Struktur ist es, dass nur mit sehr instabilen Kontaktmaterialien wie Barium oder Kalzium eine effiziente Elektroneninjektion erreicht werden kann. Diese Materialien werden aber von Sauerstoff und Wasser angegriffen. Zudem ist es sehr schwierig, für alle Emittermaterialien der drei Grundemissionsfarben rot, grün und blau, ein und dieselbe Elektrode (Kathode) zu verwenden, da dies mit erheblichen Leistungseinbußen bei einer der drei Farben einhergeht. Ein für das blau emittierende Polymermaterial optimierter Kathodenkontakt hat Nachteile für das rot emittierende Polymermaterial und umgekehrt.

Organische Leuchtdioden mit einem OLED-Aufbau, die dem Gebiet der *"small molecule"-*Technologie zugeordnet sind, weisen als organische Strukturen Schichten aus im Vakuum aufgedampften Molekülen eines oder mehrerer organischer Materialien auf. Sind die Moleküle des organischen Materials klein genug, so können sie meistens ohne Zersetzung mittels eines thermischen Prozesses aufgebracht werden. Dazu werden die Moleküle im Vakuum verdampft.

Eine typische Struktur einer organischen Leuchtdiode mit OLED-Aufbau (Maximalkonfiguration) ist wie folgt: (1) Trägersubstrat (zum Beispiel Glas); (2) Anodenkontakt (löcherinjizierend, vorzugsweise transparent, zum Beispiel aus Indium-Zinn-Oxid (ITO)); (3) Löcherinjektionsschicht (zum Beispiel aus CuPc (Kupfer-Phthalocyanin) oder Starburst-Derivate); (4) Löchertransportschicht (zum Beispiel aus TPD (Triphenyldiamin und Derivate); (5) löcherseitige Blockschicht (um Exzitonendiffusion aus dem lichtemittierenden Bereich zu verhindern und Ladungsträger-Leckage aus dem lichtemittierenden Bereich zu verhindern, zum Beispiel aus Alpha-NPB); (6) lichtemittierender Bereich (zum Beispiel CBP mit Emitterbeimischung (zum Beispiel Iridium-tris-phenylpyridin Ir(ppy)3)); (7) elektronenseitige Blockschicht (um Exzitonendiffusion aus dem lichtemittierenden Bereich zu verhindern und Ladungsträger-Leckage aus der Emissionsschicht zu verhindern, zum Beispiel aus BCP (bathocuproine)); (8) Elektronentransportschicht (zum Beispiel aus Alq₃ (Aluminium-tris-quinolate)); (9) Elektroneninjektionsschicht (zum Beispiel aus anorganischem Lithiumfluorid (LiF)); und (10) Kathodenkontakt (elektroneninjizierend, meist aus einem Metall mit niedriger Austrittsarbeit, zum Beispiel Aluminium). Die beschriebene Ausführung umfasst eine maximale Anzahl möglicher Schichten. In anderen Ausführungen können Schichten weggelassen werden. Auch kann eine Schicht mehrere Funktionen übernehmen. Zum Beispiel können die Löcherinjektionsschicht und die Löchertransportschicht oder die Löchertransportschicht und die löcherseitige Blockschicht oder die Löcherinjektionsschicht, die Löchertransportschicht und die löcherseitige Blockschicht zusammengefasst werden. Weiterhin besteht die Möglichkeiten des Einmischens der Materialien der Elektroneninjektionsschicht in die Elektronentransportschicht.

Beim OLED-Aufbau besteht weiterhin die Möglichkeit, dotierte Transportschichten mit elektrischer Dotierung zur Verbesserung der elektrischen Leitfähigkeit vorzusehen. Deren allgemeiner Aufbau sieht typischerweise wie folgt aus: (1) Trägersubstrat (zum Beispiel Glas); (2) Anodenkontakt (löcherinjizierend, vorzugsweise transparent, zum Beispiel aus ITO, aber auch aus Ag, Au und als anderer reflektierender Kontakt); (3) p-dotierte Löcher injizierende und transportierende Schicht (der Dotand ist dann ein Akzeptormaterial, welcher in der Lage ist, Elektronen von einem Matrixmaterial zu übernehmen, zum Beispiel aus m-MTDATA dotiert mit F4-TCNQ, für weitere Akzeptordotanden siehe US 6,908,783 B1); (4) löcherseitige Blockschicht (aus einem Material dessen Bandlagen zu den Bandlagen der sie umgebenden Schichten paßt, so dass Exziplexbildung zwischen Löchern auf der p-dotierten Löcher injizierenden und transportierenden Schicht und Elektronen in einem lichtemittierenden Bereich verhindert wird; zum Beispiel alpha-NPB); (5) lichtemittierender Bereich (zum Beispiel aus TCTA mit Emitterbeimischung, beispielsweise Iridium-tris-phenylpyridin Ir(ppy)3); (6) elektronenseitige Blockschicht (typischerweise dünner als die nachfolgend genannte Schicht; aus einem Material, dessen Bandlagen zu den Bandlagen der sie umgebenden Schichten paßt, so dass Exziplexbildung zwischen Löchern auf der p-dotierten Löcher injizierenden und transportierenden Schicht und Elektronen in einem lichtemittierenden Bereich verhindert wird; zum Beispiel aus BCP); (7) n-dotierte Elektronen injizierende und transportierende Schicht (der Dotand ist dann ein Donator, welcher in der Lage ist, zusätzliche Elektronen auf ein Matrixmaterial zu übertragen; zum Beispiel aus BPhen - Bathophenanthrolin dotiert mit Cäsium als anorganischem Dotanden oder W₂(Xpp)₄ (Tetrakis(1,2,3,3a,4,5,6,6a,7,8-Decahydro-1,9,9b- triazaphenalenyl)diwolfram(II); weitere Dotanden siehe US 2005/0040390 A1, US 2005/0061232 A1, WO 2005/036667 A1, WO 2005/086251 A3); und (8) Kathodenkontakt (elektroneninjizierend, meist aus einem Metall mit niedriger Austrittsarbeit, zum Beispiel A1, aber auch Ag, Au).

Die Dotanden in den dotierten Schichten müssen am Beginn des Verdampfungsprozesses zu ihrer Schichtablagerung nicht in der endgültigen Form vorliegen, solange ein alternativ verwendetes Precursor-Material beim Verdampfungsprozeß, welcher auch modifiziert sein kann, zum Beispiel durch Benutzung von Elektronenstrahlen, den Dotanden bildet. Die Herstellung der gemischten Schichten erfolgt typischerweise mittels Misch (Ko-)verdampfung.

Vorteile eines solchen OLED-Aufbaus sind ihre höhere Lichterzeugungs-Effizienz sowie die Lebensdauer und die Varianz der Struktur. Die höhere Lebensdauer der Bauelemente mit OLED-Aufbau gegenüber der Bauelemente mit PLED-Aufbau lässt sich mit der durch Vakuumreinigungsmethoden erreichten höheren Reinheit der verwendeten organischen Materialien erklären. Vorteile sind weiterhin die getrennte Optimierbarkeit der Eigenschaften der einzelnen Schichten, der einstellbare große Abstand des lichtemittierenden Bereiches zu den Elektrodenkontakten. Bei dotierten Bauelementen vom pin-OLED-Typ kommen niedrige Betriebsspannung und eine Varianz der Elektrodenmaterialien hinzu. Wie zum Beispiel in dem Dokument US 2004/0251816 A1 und in Zhou et al. (Appl. Phys. Lett. 81, 922 (2002)) dargestellt ist, lässt sich diese Struktur außerdem auch leicht invertieren und top-emittierend oder ganz transparent ausführen (vgl. US 2006/0033115 A1).

Der Nachteil solcher Bauelemente besteht darin, dass eine laterale Strukturierung der OLED-Struktur zum Aufbau verschiedenfarbiger Pixel in einem Display üblicherweise mittels Schattenmasken erfolgt. Dieser Prozess hat Begrenzungen hinsichtlich der kleinsten erreichbaren Pixelgrößen, die weniger als etwa 50µm beträgt. Der Schattenmaskenprozess ist in einer Fertigung ein relativ aufwendiger Prozess. Der Ink-Jet-Prozess, wie er zum Auftragen von Polymermaterialien verwendet wird, ist für kleine Moleküle beim Ausbilden niedermolekularer Schichten wegen der Unlöslichkeit der organischen Materialien der kleinen Moleküle nicht oder nur begrenzt nutzbar. Ein alternativer Prozess ist LITI (*"Laser Induced Thermal Imaging"*), welcher aber seinerseits Begrenzungen vor allem bei der Wahl der prozesskompatiblen Materialien hat.

Es sind weiterhin organische lichtemittierende Bauelemente mit einem hybriden Aufbau bekannt, die deshalb auch als hybriden organische Bauelemente bezeichnet werden. In dem Dokument US 2003 / 020073 A1 wird die Verwendung von aufgedampften niedermolekularen Blockschichten und Elektronentransportschichten auf einer polymeren Löchertransportschicht beschrieben. Allerdings ist bei dieser Anordnung die Injektion von Ladungsträgern, nämlich Elektronen von dem Kathodenkontakt in die niedermolekulare Elektronentransportschicht, problematisch, was die Betriebsspannung des Bauelementes erhöht.

Das Dokument WO 2005/086251 beschäftigt sich mit der Verwendung eines Metallkomplexes als n-Dotant für ein organisches halbleitendes Matrixmaterial, ein organisches Halbleitermaterial und ein elektronisches Bauteil sowie als Dotant und Ligand.

Es wurde die Wechselwirkung zwischen Akzeptormaterialien und einer Metallelektrode aus Gold untersucht (Koch et al.: "Optimized Hole Injection with Strong Electron Acceptors at Organic-Metal Interfaces", Physical Review Letters 95, Seiten 237601-1 bis 237601-4, 2005). Hierbei wurde die Goldelektrode mit einer (sub)molekularen Schicht aus F4-TCNQ überzogen. Es wurde eine verbesserte Löcherinjektion gefunden.

He et al. ("Very high-efficiency and low voltage phosphorescent organic light-emitting diodes based on a p-i-n junction", Journal of Applied Physics, Vol. 95, Nr. 10, Seiten 5773 bis 5777, 2004) beschreiben eine effiziente phosphoreszente organische lichtemittierende Diode basierend auf einem p-i-n-Übergang.

Im Dokument EP 1 511 094 A2 ist ein Licht emittierendes Bauelement offenbart, bei dem organische Molekülschichten und Polymerschichten vorgesehen sind.

Die Eigenschaften der verschiedenen beteiligten Materialien können im PLED-Aufbau und im OLED-Aufbau durch die Energielagen des niedrigsten unbesetzten Molekülorbitals (LUMO) und des höchsten besetzten Molekülorbitals (HOMO) beschrieben werden. Löchertransportschichten, einschließlich zugehöriger Blockmaterialien, haben meistens HOMOs im Bereich von 4.5eV bis 5.5eV unter Vakuumniveau, LUMOs im Bereich von 1,5eV bis 3eV.

Bei Materialien für den lichtemittierenden Bereich liegen die HOMOs im Bereich von 5eV bis 6.5eV und die LUMOs im Bereich von 2 bis 3eV. Bei Materialien für Elektronentransportschichten, einschließlich geeigneter Blockmaterialien, liegen das HOMO im Bereich von 5,5eV bis 6.8eV und das LUMO im Bereich von 2.3eV bis 3.3eV. Die Austrittsarbeiten für das Herauslösen von elektrischen Ladungsträgern liegen bei den Materialien für den Anodenkontakt im Bereich von 4eV bis 5eV und für den Kathodenkontakt im Bereich von 3eV bis 4.5eV.

### Zusammenfassung der Erfindung

Aufgabe der Erfindung ist es, ein lichtemittierendes Bauelement mit erhöhter Flexibilität hinsichtlich des Aufbaus und verbesserter Injektion von Ladungsträgern aus den elektrischen Kontakten in den lichtemittierenden Schichtstapel zu schaffen. Darüber hinaus soll hierbei eine gute Strukturierbarkeit des lichtemittierenden Bauelementes erhalten bleiben.

Diese Aufgabe wird erfindungsgemäß durch ein lichtemittierendes Bauelement nach dem unabhängigen Anspruch 1 gelöst. Bevorzugte Ausgestaltungen der Erfindung sind Gegenstand von abhängigen Unteransprüchen.

Mittels der Kombination der polymeren Schicht aus dem Polymermaterial und der niedermolekularen Schicht mit im Vakuum aufgebrachten kleinen Molekülen eines organischen Materials in dem lichtemittierenden Bauelement wird eine höhere Flexibilität für den lichtemittierenden Schichtstapel erreicht, wobei mit der Ausbildung der polymeren Schicht eine leichtere Strukturierbarkeit des Bauelementes zum Erzeugen von Pixelbereichen, welche Licht in verschiedenen Farben aussenden, erreicht wird, ohne dass der Einsatz von Schattenmasken notwendig ist, wie dieses für lichtemittierende organische Bauelemente üblich ist, die auf Basis von kleinen Molekülen organischer Materialien gebildet werden.

Es besteht weiterhin der Vorteil, dass das Material für die Elektrodenkontakte frei wählbar ist. Mögliche Verluste bei der Injektion von Ladungsträgern sind minimiert oder sogar ganz vermieden. Es sind stabile lichtemittierende Bauelemente mit einer langen Lebensdauer geschaffen. Die sonst übliche Koverdampfung von organischen Materialien ist nicht notwendig.

Bei einer Fortbildung der Erfindung ist vorgesehen, dass der Schichtstapel eine weitere niedermolekulare Schicht mit einer Schichtdicke zwischen 0.5nm und 20nm aus im Vakuum aufgebrachten kleinen Molekülen eines weiteren organischen, mittels Vakuumverdampfung abscheidbaren Materials, welches von dem organischen Material verschieden ist, umfasst, wobei:
- die weitere niedermolekulare Schicht benachbart zu dem Anodcnkontakt angeordnet ist und
- die kleinen Moleküle der weiteren niedermolekularen Schicht gebildet sind als die Akzeptormoleküle mit dem Reduktionspotential gegenüber Fc / Fc⁺ (Ferrocen / Ferrocenium Redoxpaar) von mindestens etwa -0.3V.

Eine zweckmäßige Ausgestaltung der Erfindung kann vorsehen, dass die Donatormoleküle ein Oxidationspotential gegenüber Fc / Fc⁺ (Ferrocen / Ferrocenium Redoxpaar) von höchstens etwa -2.0V, bevorzugt von höchstens etwa -2.2V aufweisen.

Eine bevorzugte Weiterbildung der Erfindung sieht vor, dass die Akzeptormoleküle ein Reduktionspotential gegenüber Fc / Fc⁺ (Ferrocen / Ferrocenium Redoxpaar) von mindestens etwa 0V, bevorzugt von mindestens etwa 0.24V aufweisen.

Bei einer vorteilhaften Ausführungsform der Erfindung ist vorgesehen, dass die Donatormoleküle und / oder die Akzeptormoleküle eine molare Masse zwischen etwa 100g/mol und etwa 2000g/mol, bevorzugt zwischen etwa 200g/mol und etwa 1000g/mol aufweisen.

Bei einer zweckmäßigen Ausgestaltung der Erfindung ist vorgesehen, dass die Donatormoleküle zumindest teilweise als W₂(Xpp)₄-Moleküle gebildet sind.

Bei einer Fortbildung der Erfindung ist vorgesehen, dass die Akzeptormoleküle zumindest teilweise als Cl₄DCNQI-Moleküle gebildet sind.

Eine zweckmäßige Ausgestaltung der Erfindung kann vorsehen, dass die niedermolekulare und / oder die weitere niedermolekulare Schicht eine Schichtdicke zwischen etwa 1nm und etwa 10nm und bevorzugt zwischen etwa 1nm und etwa 5nm aufweisen.

Bei einer vorteilhaften Ausführungsform der Erfindung ist vorgesehen, dass die polymere Schicht eine Schichtdicke zwischen etwa 20nm und etwa 500nm, bevorzugt zwischen etwa 40nm und etwa 150nm und weiter bevorzugt zwischen etwa 50nm und etwa 100nm aufweist.

Bei einer zweckmäßigen Ausgestaltung der Erfindung ist vorgesehen, dass die polymere Schicht aus einem Polymermaterial ausgewählt aus der folgenden Gruppe von Polymermaterialien ist: Polyfluorene, PPVs, Polyspiros, Polythiophene und Polyparaphenylene.

Bei einer Fortbildung der Erfindung ist vorgesehen, dass zwischen dem Anodenkontakt und der polymeren Schicht eine polymere Löcherinjektionsschicht angeordnet ist.

Eine zweckmäßige Ausgestaltung der Erfindung kann vorsehen, dass die polymere Löcherinjektionsschicht eine Schichtdicke zwischen etwa 20nm und etwa 500nm, bevorzugt zwischen etwa 40nm und etwa 150nm und weiter bevorzugt zwischen etwa 50nm und etwa 100nm aufweist.

Eine bevorzugte Weiterbildung der Erfindung sieht vor, dass zwischen der niedermolekularen Schicht und der polymeren Schicht eine niedermolekulare organische Elektronentransportschicht angeordnet ist.

Bei einer vorteilhaften Ausführungsform der Erfindung ist vorgesehen, dass die niedermolekulare organische Elektronentransportschicht ein organisches Matrixmaterial umfasst, welches mit einem niedermolekularen organischen Donatormaterial elektrisch dotiert ist.

Bei einer zweckmäßigen Ausgestaltung der Erfindung ist vorgesehen, dass die niedermolekulare organische Elektronentransportschicht eine Dotierungskonzentration (Donatormaterial-Moleküle : Matrixmaterial-Moleküle) zwischen 1 : 1000 und 1 : 2, bevorzugt zwischen 1 : 100 und 1 : 5 und weiter bevorzugt zwischen 1 : 100 und 1 : 10 aufweist.

Bei einer Fortbildung der Erfindung ist vorgesehen, dass das organische Donatormaterial eine molare Masse zwischen etwa 100g/mol und etwa 2000g/mol und bevorzugt zwischen etwa 200g/mol und etwa 1000g/mol aufweist.

Eine zweckmäßige Ausgestaltung der Erfindung kann vorsehen, dass die niedermolekulare organische Elektronentransportschicht eine Schichtdicke zwischen etwa 10nm und etwa 500nm, bevorzugt zwischen etwa 20nm und etwa 200nm und weiter bevorzugt zwischen etwa 20nm und etwa 100nm aufweist.

Eine bevorzugte Weiterbildung der Erfindung sieht vor, dass das niedermolekulare organische Donatormaterial W₂(Xpp)₄ ist.

Bei einer vorteilhaften Ausführungsform der Erfindung ist vorgesehen, dass zwischen der niedermolekularen Schicht und der polymeren Schicht eine niedermolekulare organische Blockschicht angeordnet ist.

Bei einer zweckmäßigen Ausgestaltung der Erfindung ist vorgesehen, dass die niedermolekulare organische Blockschicht eine Schichtdicke zwischen etwa 2nm und etwa 50nm, bevorzugt zwischen etwa 2nm und etwa 30nm und weiter bevorzugt zwischen etwa 5nm und etwa 20nm aufweist.

Bei einem weiteren nicht erfinderischem Beispiel ist vorgesehen, dass zwischen dem Kathodenkontakt und der polymeren Schicht eine polymere Elektroneninjektionsschicht angeordnet ist, wenn die niedermolekulare Schicht benachbart zu dem Anodenkontakt angeordnet ist.

Eine zweckmäßige Ausgestaltung kann vorsehen, dass die polymere Elektroneninjektionsschicht eine Schichtdicke zwischen etwa 20nm und etwa 500nm, bevorzugt zwischen etwa 40nm und etwa 150nm und weiter bevorzugt zwischen etwa 50nm und etwa 100nm aufweist.

Ein weiteres nicht erfinderisches Beispiel sieht vor, dass zwischen der niedermolekularen Schicht und der polymeren Schicht eine niedermolekulare organische Löchertransportschicht angeordnet ist, wenn die niedermolekulare Schicht benachbart zu dem Anodenkontakt angeordnet ist.

Bei einer vorteilhaften Ausführungsform ist vorgesehen, dass die niedermolekulare organische Löchertransportschicht ein organisches Matrixmaterial umfasst, welches mit einem niedermolekularen organischen Akzeptormaterial elektrisch dotiert ist.

Bei einer zweckmäßigen Ausgestaltung ist vorgesehen, dass die niedermolekulare organische Löchertransportschicht eine Dotierungskonzentration (Akzeptormaterial-Moleküle : Matrixmaterial-Moleküle) zwischen 1 : 1000 und 1 : 2, bevorzugt zwischen 1 : 100 und 1 : 5 und weiter bevorzugt zwischen 1 : 100 und 1 : 10 aufweist.

Bei einer Fortbildung der Erfindung ist vorgesehen, dass das organische Akzeptormaterial eine molare Masse zwischen etwa 100g/mol und etwa 2000g/mol und bevorzugt zwischen etwa 200g/mol und-etwa 1000g/mol aufweist.

Eine zweckmäßige Ausgestaltung kann vorsehen, dass die niedermolekulare organische Löchertransportschicht eine Schichtdicke zwischen etwa 10nm und etwa 500nm, bevorzugt zwischen etwa 20nm und etwa 200nm und weiter bevorzugt zwischen etwa 20nm und etwa 100nm aufweist.

Eine bevorzugte Weiterbildung sieht vor, dass die niedermolekulare organische Löchertransportschicht zumindest teilweise aus dem niedermolekularen organischen Akzeptormaterial Cl₄DCNQI besteht.

Bei einer zweckmäßigen Ausgestaltung ist vorgesehen, dass die weitere niedermolekulare organische Blockschicht eine Schichtdicke zwischen etwa 2nm und etwa 50nm, bevorzugt zwischen etwa 2nm und etwa 30nm und weiter bevorzugt zwischen etwa 5nm und etwa 20nm aufweist.

Bei einer Fortbildung der Erfindung ist vorgesehen, dass die Anordnung von Schichten gemäß mindestens einem Aufbau ausgewählt aus der folgenden Gruppe von Aufbauten gebildet ist: invertierter Aufbau; nicht-invertierter Aufbau; Licht, welches in dem lichtemittierenden Schichtstapel erzeugt wird, von dem Substrat weg emittierender Aufbau (" *top-emission* ") und Licht, welches in dem lichtemittierenden Schichtstapel erzeugt wird, durch das Substrat emittierender Aufbau (" *bottom-emission* ").

Eine zweckmäßige Ausgestaltung der Erfindung kann vorsehen, dass die Anordnung von Schichten mit dem Substrat transparent ist.

Eine bevorzugte Weiterbildung der Erfindung sieht vor, durch einen Grundkontakt und einen Deckkontakt, welche mittels des Anodenkontaktes oder des Kathodenkontaktes gebildet sind und welche aus einem oder mehreren Metallen, einer Kombination eines Metalls und eines entarteten Halbleitematerials oder einer Metalllegierung sind.

Das Auftragen der polymeren Schichten, die aus einem oder mehreren Polymermaterialien gebildet werden, erfolgt mit Hilfe einfacher Mittel mit hoher Präzision. Eine auf diese Weise erreichte Strukturierung dient gleichzeitig der Strukturierung des herzustellenden lichtemittierenden Bauelementes, ohne daß aufwendige Strukturierungsschritte oder -mittel erforderlich sind. In einer bevorzugten Ausgestaltung ist vorgesehen, daß die polymeren Schichten mittels Tintenstrahldruck ("*Ink-Jet-Printing*") aufgebracht werden.

Die Einbeziehung der niedermolekularen Schichten aus einem oder mehreren organischen Materialien vermeidet es, daß infolge des Vorhandenseins von in der Regel nur zwei disjunkten Lösungsmitteln für das Auftragen der Polymermaterialien die Modifikation der polymeren Schichten beschränkt ist und erhöht auf diese Weise die Variationsmöglichkeiten des Schichtaufbaus des Bauelementes. Bei der Herstellung des lichtemittierenden Bauelementes können die Donator- und / oder die Akzeptormoleküle für die niedermolekulare(n) Schicht(en) zunächst im Vakuum aus einem Precursor erzeugt werden, indem ein als der Precursor wirkendes organisches Ausgangsmaterial verdampft wird, welches während des Verdampfungsprozesses die Donator- / Akzeptormoleküle bildet.

Die erfindungsgemäßen lichtemittierenden Bauelemente können als Bauteil in verschiedensten Anwendungen genutzt werden. Diese Anwendungsmöglichkeiten umfassen insbesondere die Verwendung der lichtemittierenden Bauelemente in Displays, Anzeigen und Beleuchtungseinrichtungen jeglicher Art. In einer Ausführungsform wird das Bauelement mit Pixel-bereichen gebildet, die Licht unterschiedlicher Farben emittieren, insbesondere rotes, grünes und blaues Licht. Auf diese Weise ist ein mehrfarbiges Bauelement gebildet.

### Beschreibung bevorzugter Ausführungsbeispiele der Erfindung

Die Erfindung wird im folgenden anhand von Ausführungsbeispielen unter Bezugnahme auf Figuren einer Zeichnung näher erläutert. Hierbei zeigen:
- Fig. 1: eine schematische Darstellung eines lichtemittierenden Bauelementes mit einer Anordnung von Schichten mit einem nicht-invertierten Aufbau; und
- Fig. 2: eine schematische Darstellung eines weiteren lichtemittierenden Bauelementes mit einer Anordnung von Schichten mit einem invertierten Aufbau.

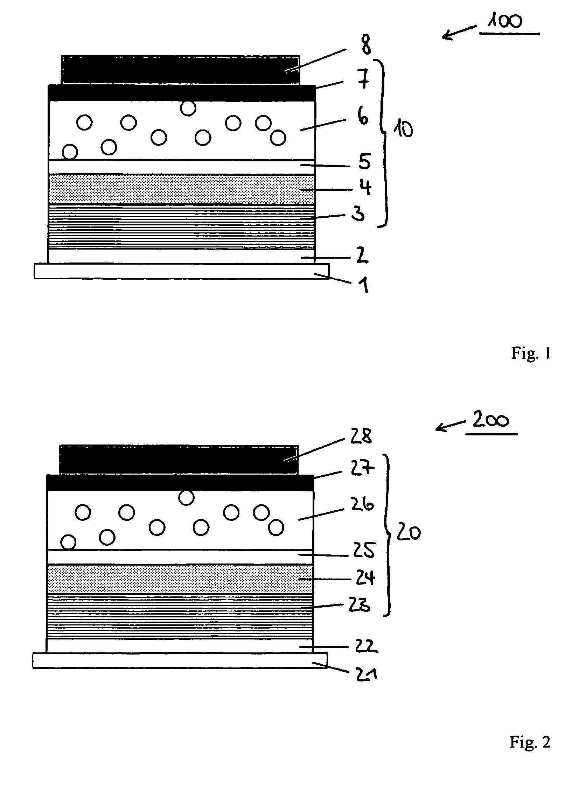

Fig. 1 zeigt eine schematische Darstellung eines lichtemittierenden Bauelementes 100 mit einer Anordnung von Schichten mit einem nicht-invertierten Aufbau, bei dem auf einem Substrat 1 ein Anodenkontakt 2 gebildet ist. Das lichtemittierende Bauteil 100 emittiert Licht, welches in einem lichtemittierenden Schichtstapel 10 erzeugt wird, durch das Substrat 1, weshalb das Substrat 1 und der Anodenkontakt 2 für das erzeugte Licht transparent sind. Das Substrat 1 weist eine geeignete Schichtdicke auf. Der transparent ausgeführte Anodenkontakt 2 verfügt über eine Schichtdicke zwischen etwa 10nm und etwa 500nm. In anderen Ausführungen beträgt die Schichtdicke zwischen etwa 20nm und etwa 200nm. Als Material für den Anodenkontakt 2 werden beispielsweise ein entartetes organisches Halbleitermaterial, zum Beispiel Indium-Zinn-Oxid (ITO), oder ein Metall verwendet, welches eine dünne Schichtdicke aufweist und semitransparent ist.

Eine polymere Löcherinjektionsschicht 3 aus einem Polymermaterial ist gemäß Fig. 1 auf dem Anodenkontakt 2 angeordnet. Die polymere Löcherinjektionsschicht weist eine Schichtdicke zwischen etwa 20nm und etwa 500nm auf. In anderen Ausführungen beträgt die Schichtdicke zwischen etwa 40nm und 150nm, bevorzugt zwischen etwa 50nm und etwa 100nm.

Eine polymere Emissionsschicht 4 aus einem Polymermaterial ist gemäß Fig. 1 auf der polymeren Löcherinjektionsschicht 3 angeordnet. Die polymere Emissionsschicht 4 ist in der Ausführungsform nach Fig. 1 löchertransportierend gebildet, d. h. sie transportiert elektrische Ladungsträger in Form von Löchern. Die polymere Emissionsschicht 4 verfügt über eine Schichtdicke zwischen etwa 20nm und etwa 500nm. In anderen Ausführungen beträgt die Schichtdicke zwischen etwa 40nm und 150nm, bevorzugt zwischen etwa 50nm und etwa 100nm. Die polymere Emissionsschicht 4 ist unter Verwendung mindestens eines der folgenden Polymermaterialien gebildet: Polyfluorene, PPVs, Polyspiros, Polythiophene und Polyparaphenylene.

Eine niedermolekulare elektronenseitige Blockschicht 5 aus kleinen Molekülen eines oder mehrerer organischer Materialien ist gemäß Fig. 1 auf der polymeren Emissionsschicht 4 angeordnet. Mit Hilfe der elektronenseitigen Blockschicht 5 werden elektrische Ladungsträger in Form von Löchern an einer Wanderung aus der polymeren Emissionsschicht 4 heraus gehindert. Darüber hinaus dient die elektronenseitige Blockschicht 5 der Blockierung von Exzitonen, d. h. Elektronen-Loch-Paaren, aus der polymeren Emissionsschicht 4. Des weiteren werden mit Hilfe der elektronenseitigen Blockschicht 5 hohe Dichten von Ladungsträgern in Form von Elektronen in einer niedermolekularen Elektronentransportschicht 6 und hohe Dichten von Ladungsträgern in Form von Löchern in der polymeren Emissionsschicht 4 voneinander separiert, so daß die Bildung von Exziplexen verhindert ist. Eine solche ExziplexBildung minimiert die Effizienz des lichtemittierenden Bauelementes 100. Die elektronenseitige Blockschicht 5 weist eine Schichtdicke zwischen etwa 2nm und etwa 50nm auf. In anderen Ausführungen beträgt die Schichtdicke zwischen etwa 5nm und etwa 30nm, bevorzugt zwischen etwa 5nm und etwa 20nm.

Die niedermolekulare Elektronentransportschicht 6 aus kleinen Molekülen eines oder mehrerer organischer Materialien ist gemäß Fig. 1 auf der elektronenseitigen Blockschicht 5 angeordnet. In einer bevorzugten Ausgestaltung ist die niedermolekulare Elektronentransportschicht 6 mit einem starken niedermolekularen organischen Donatormaterial elektrisch dotiert, welches in ein organisches Matrixmaterial eindotiert ist. Das niedermolekulare organische Donatormaterial ist in der Lage, Elektronen an das organische Matrixmaterial abzugeben. Die molare Masse des organischen Donatormaterials beträgt zwischen etwa 100g / mol und 2000g / mol. In einer anderen Ausgestaltung beträgt die molare Masse zwischen etwa 200g /mol und etwa 1000g / mol. Das Verhältnis der Donatormaterial-Moleküle zu den Matrixmaterial-Molekülen, welches als molare Dotierungskonzentration bezeichnet wird, beträgt zwischen 1 : 1000 und 1 : 2, in anderen Ausführungen zwischen 1 : 100 und 1 : 5 oder zwischen 1 : 100 und 1 : 10. Die niedermolekulare Elektronentransportschicht 6 ist mit einer Dicke zwischen etwa 10nm und 500nm gebildet. In anderen Ausführungen beträgt die Schichtdicke zwischen etwa 20nm und etwa 200nm oder zwischen etwa 20nm und etwa 100nm.

Eine niedermolekulare Schicht 7 mit im Vakuum aufgebrachten kleinen organischen Donatormolekülen ist gemäß Fig. 1 auf der niedermolekularen Elektronentransportschicht 6 angeordnet. Die Donatormoleküle weisen gegenüber Fc / Fc⁺ (Ferrocen / Ferrocenium Redoxpaar) ein Oxidationspotential -1.5V auf. In anderen Ausgestaltungen beträgt das Oxidationspotential höchstens etwa -2.0V oder höchstens etwa -2.2V. Dieses Oxidationspotential korrespondiert mit einem höchsten besetzten Molekülorbital (HOMO) der Donatormoleküle von weniger als etwa 3.3eV, von weniger als etwa 2.8eV und von weniger als 2.6eV. Das HOMO der Donatormoleküle kann aus cyclovoltammetrischen Messungen des Oxidationspotentials bestimmt werden. Wenn die organischen Donatormoleküle in einer zweckmäßigen Ausgestaltung während der Schichtbildung der niedermolekularen Schicht 7 aus einem Precursor erzeugt werden, so beziehen sich die Angaben für das HOMO auf die so letztlich erzeugten Donatormoleküle. Aufgrund der angegebenen Eigenschaften der Donatormoleküle kommt es zur Ausbildung einer Ionisierung der Donatormoleküle (positiv geladen) aufgrund einer Reaktion mit einem Kathodenkontakt 8 (vgl. Fig. 1) und / oder den organischen Molekülen der benachbarten niedrigmolekularen Elektronentransportschicht 6. Eine so gebildete Raumladung unterstützt die Injektion von Ladungsträgern aus dem Kathodenkontakt 8 in die niedermolekulare Elektronentransportschicht 6.

Der Kathodenkontakt 8 ist gemäß Fig. 1 auf der niedermolekularen Schicht 7 mit den Donatormolekülen angeordnet. Der Kathodenkontakt 8 weist eine Schichtdicke von wenigstens 10nm auf. Als Material für den Kathodenkontakt 8 werden Metalle, zum Beispiel Al, Ag, Au, Ca und Ba, Metalllegierungen, eine Kombination von Metall und einem entarteten Halbleiter, zum Beispiel ITO, verwendet.

In alternativen Ausgestaltungen (nicht dargestellt) des lichtemittierenden Bauelementes 100 können eine oder mehrere der Schichten im lichtemittierenden Schichtstapel 10 weggelassen werden. Beispielsweise kann es sich hierbei um die polymere Löcherinjektionsschicht 3, die niedermolekulare elektronenseitige Blockschicht 5 und / oder die niedermolekulare Elektronentransportschicht 6 handeln. Das lichtemittierende Bauelement 100 kann alternativ auch als das Licht, welches in dem lichtemittierenden Schichtstapel 10 erzeugt wird, vom Substrat 1 weg emittierend ausgeführt sein. In diesem Fall ist der Anodenkontakt 2 für das erzeugte Licht reflektierend, und der Kathodenkontakt 8 ist transparent. In einer weiteren Ausgestaltung sind sowohl der Anodenkontakt 2 als auch der Kathodenkontakt 8 transparent, so daß ein (semi-)transparentes lichtemittierendes Bauelement gebildet ist.

In einer weiteren nicht erfinderischen Ausführungsform (nicht dargestellt) des lichtemittierenden Bauelementes 100 ist benachbart zu dem Anodenkontakt 2 eine niedermolekulare organische Schicht aus Akzeptormolekülen eines oder mehrerer organischer Materialien gebildet, die als Injektionsschicht für elektrische Ladungsträger in Form von Löchern aus dem Anodenkontakt 2 in den lichtemittierenden Schichtstapel 10 dient. Die niedermolekulare Schicht mit den Akzeptormolekülen weist bevorzugt die gleichen Eigenschaften auf, wie sie unten in Verbindung mit der Ausführungsform nach Fig. 2 näher erläutert werden.

Nachfolgend werden Beispiele für die vorangehend unter Bezugnahme auf Fig. 1 erläuterte Ausführungsform des lichtemittierenden Bauelementes näher beschrieben.

### Beispiel 1

Nach einem Beispiel 1 weist das lichtemittierende Bauelement den folgenden Aufbau auf, welcher eine niedermolekulare organische Injektionsschicht aus Donatormolekülen eines organischen Materials umfasst:
- 1.1: transparentes Substrat (Glas)
- 1.2: Anodenkontakt (Indium-Zinn Oxid (ITO); 90nm dick)
- 1.3: polymere Löcherinjektionsschicht, (PEDOT :PSS (Baytron-P von H.C.Starck, Deutschland); 80nm dick (spin-coated aus wässriger Dispersion)
- 1.4: polymere löchertransportierende Emissionsschicht (MEH-PPV; 70nm dick (spin-coated aus Toluol Lösung)
- 1.7: niedermolekulare Donatormolekülschicht (W₂(Xpp)₄; 2nm dick)
- 1.8: Kathodenkontakt (reflektierend; A1)

### Beispiel 2

Nach einem Beispiel 2 weist das lichtemittierende Bauelement den folgenden Aufbau auf, welcher eine niedermolekulare organische Injektionsschicht aus Donatormolekülen eines organischen Materials umfasst:
- 2.1: transparentes Substrat (Glas)
- 2.2: Anodenkontakt (Indium-Zinn Oxid (ITO); 90nm dick)
- 2.3: polymere Löcherinjektionsschicht (PEDOT :PSS (Baytron-P von H.C.Starck, Deutschland); 80nm dick (spin-coated aus wässriger Dispersion)
- 2.4: polymere löchertransportierende Emissionsschicht (MEH-PPV; 60nm dick (spin-coated aus Toluol Lösung)
- 2.6: n-dotierte niedermolekulare Elektronentransportschicht (aus Alq3 dotiert mit W₂(Xpp)₄, Massendotierungskonzentration 20% (entspricht einer molaren Dotierkonzentration von etwa 10%); 20nm dick)
- 2.7: niedermolekulare Donatormolekül-Schicht (W₂(Xpp)₄; 2nm dick)
- 2.8: Kathodenkontakt (reflektierend; Al)

Durch die eingefügte n-dotierte Elektronentransportschicht 2.6 kann die optische Kavität des hybriden Bauelementes angepasst werden, ohne Einbuße bezüglich elektro-optischen Kenndaten Betriebsspannung und Lichterzeugungseffizienz. Die n-dotierte Elektronentransportschicht 2.6 wird im Vakuum mittels Mischverdampfung aus zwei unabhängig geregelten Verdampfungsquellen (für Matrixmaterial und Donatormoleküle) hergestellt. Die Donatoren in den Schichten 2.6 und 2.7 können auch Moleküle verschiedener organischer Materialien sein.

### Beispiel 3

Nach einem Beispiel 3 weist das lichtemittierende Bauelement den folgenden Aufbau auf, welcher eine niedermolekulare organische Injektionsschicht aus Donatormolekülen eines organischen Materials umfasst:
- 3.1: transparentes Substrat (Glas)
- 3.2: Anodenkontakt (Indium-Zinn Oxid (ITO); 90nm)
- 3.3: polymere Löcherinjektionsschicht (PEDOT :PSS (Baytron-P von H.C.Starck, Deutschland); 80nm dick (spin-coated aus wässriger Dispersion)
- 3.4: polymere löchertransportierende Emissionsschicht (MEH-PPV; 60nm dick (spin-coated aus Toluol Lösung)
- 3.6: niedermolekulare Elektronentransportschicht (Alq₃; 20nm dick)
- 3.7: niedermolekulare Donatormolekül-Schicht (W₂(Xpp)₄; 2nm dick)
- 3.8: Kathodenkontakt (reflektierend; A1)

Im Gegensatz zum Beispiel 2 weist dieses Bauelement eine undotierte niedermolekulare Elektronentransportschicht auf. Dadurch ergaben sich gegenüber Beispiel 2 leichte Einbußen bei der gemessenen Betriebsspannung. Es kann aber auf einen Mischverdampfungsprozess verzichtet werden.

### Beispiel 4

Bei einem Beispiel 4 weist das lichtemittierende Bauelement den folgenden Aufbau auf, welcher eine niedermolekulare organische Injektionsschicht aus Donatormolekülen eines organischen Materials umfasst:
- 4.1: transparentes Substrat (Glas)
- 4.2: Anodenkontakt (Indium-Zinn Oxid (ITO); 90nm)
- 4.3: polymere Löcherinjektionsschicht (PEDOT :PSS (Baytron-P von H.C.Starck, Deutschland); 80nm dick (spin-coated aus wässriger Dispersion)
- 4.4: polymere löchertransportierende Emissionsschicht (MEH-PPV; 60nm dick (spin-coated aus Toluol Lösung)
- 4.5: elektronenseitige Blockschicht (BPhen (bathophenanthrolin); 5nm dick)
- 4.6: n-dotierte niedermolekulare Elektronentransportschicht (Alq₃ dotiert mit W₂(Xpp)₄, Massendotierungskonzentration 20% (entspricht einer molaren Dotierkonzentration von etwa 10%); 15nm dick)
- 4.7: niedermolekulare Donatormolekül-Schicht (W₂(Xpp)₄; 2nm dick)
- 4.8: Kathodenkontakt (reflektierend; A1)

Durch die eingefügte n-dotierte Elektronentransportschicht 4.6 kann die optische Kavität des lichtemittierenden Bauelementes angepasst werden, ohne Einbuße bezüglich elektro-optischen Kenndaten Betriebsspannung und Lichterzeugungseffizienz. Die n-dotierte Elektronentransportschicht 4.6 wird im Vakuum mittels Mischverdampfung aus zwei unabhängig geregelten Verdampfungsquellen (für Matrixmaterial und Dotand) hergestellt. Die Donatormoleküle in den Schichten 4.6 und 4.7 können auch Moleküle unterschiedlicher organischer Materialien sein.

Für alle lichtemittierenden Bauelemente nach den Beispielen 1 bis 4 wurde eine geringe Betriebsspannungen gemessen, obwohl kein unedles Metall für den Kathodenkontakt zum Einsatz kam. Ein Wert von 100cd / m² wurde in allen Fällen bei Betriebsspannung von weniger als 4V erreicht. Die Farbe des emittierten Lichtes war gelb. Das LUMO von MEH-PPV liegt zwischen -2.8eV und -2.9eV. Die Stromeffizienzen mit MEH-PPV sind generell sehr klein. Es wurden 0.5cd / A gemessen.

Fig. 2 zeigt eine schematische Darstellung eines nicht erfinderischen lichtemittierenden Bauelementes 200, bei dem auf einem Substrat 21 ein lichtemittierender Schichtstapel 20 in invertierter Ausführung und Licht, welches in dem lichtemittierenden Schichtstapel 20 erzeugt wird, durch das Substrat 21 emittierend gebildet ist. Zu diesem Zweck ist das Substrat 21 für das in dem lichtemittierenden Schichtstapel 20 erzeugte Licht transparent.

Ein Kathodenkontakt 22 ist gemäß Fig. 2 auf dem Substrat 21 angeordnet. Der Kathodenkontakt 22 weist eine Schichtdicke zwischen etwa 10nm und etwa 500nm auf. In einer anderen Ausführung beträgt die Schichtdicke zwischen etwa 20nm und etwa 200nm. Als Material für den ebenfalls transparent ausgeführten Kathodenkontakt 22 wird ein entartetes organisches Halbleitermaterial, beispielsweise Indium-Zinn-Oxid (ITO), oder ein Metall verwendet, zum Beispiel Ca, Ba, Au, Ag oder Al. Auch eine Ausführung aus einer Metalllegierung kann vorgesehen sein.

Eine polymere Elektroneninjektionsschicht 23 aus einem Polymermaterial ist gemäß Fig. 2 auf dem Kathodenkontakt 22 angeordnet. Die polymere Elektroneninjektionsschicht 23 weist eine Schichtdicke zwischen etwa 20nm und etwa 500nm auf. In anderen Ausgestaltungen beträgt die Schichtdicke zwischen etwa 40nm und 150nm, bevorzugt zwischen etwa 50nm und etwa 100nm.

Eine polymere Emissionsschicht 24 ist aus einem Polymermaterial ist gemäß Fig. 2 auf der polymeren Elektroneninjektionsschicht 23 angeordnet. Die polymere Emissionsschicht 24 ist für elektrische Ladungsträger in Form von Elektronen transportierend, d. h. aus der polymeren Elektroneninjektionsschicht 23 injizierte Elektronen werden transportiert. Die polymere Emissionsschicht 24 verfügt über eine Schichtdicke zwischen etwa 20nm und etwa 500nm. In anderen Ausführungsformen beträgt die Schichtdicke zwischen etwa 40nm und etwa 150nm, bevorzugt zwischen etwa 50nm und etwa 100nm. Als Polymermaterial können die folgenden Materialien verwendet werden: Polyfluorene, PPVs, Polyspiros, Polythiophene und Polyparaphenylene.

Eine niedermolekulare löcherseitige Blockschicht 25 aus einem oder mehreren organischen Materialien ist gemäß Fig. 2 auf der polymeren Emissionsschicht 24 angeordnet. Die löcherseitige Blockschicht 25 dient der zusätzlichen Blockierung von elektrischen Ladungsträgern in Form von Elektronen aus der polymeren Emissionsschicht 24. Darüber hinaus werden Exzitonen aus der polymeren Emissionsschicht 24 blockiert. Des weiteren erfüllt die löcherseitige Blockschicht 25 die Funktion einer Separierung von hohen Ladungsträgerdichten in Form von Löchern in einer niedermolekularen Löchertransportschicht 26 und hohen Ladungsträgerdichten in Form von Elektronen in der polymeren Emissionsschicht 24. Auf diese Weise wird die Bildung von Exziplexen verhindert, welche die Effizienz des lichtemittierenden Bauteils 200 minimieren würden. Die löcherseitige Blockschicht 25 weist eine Schichtdicke zwischen etwa 2nm und etwa 50nm auf. In anderen Ausführungen beträgt die Schichtdicke zwischen etwa 5nm und etwa 30nm, bevorzugt zwischen etwa 5nm und etwa 30nm.

Die niedermolekulare Löchertransportschicht 26 ist gemäß Fig. 2 auf der löcherseitigen Blockschicht 25 angeordnet und aus einem oder mehreren organischen Materialien gebildet. Die niedermolekulare Löchertransportschicht 26 weist eine Schichtdicke zwischen etwa 10nm und etwa 500nm auf. In anderen Ausführungen beträgt die Schichtdicke zwischen etwa 20nm und etwa 200nm, bevorzugt zwischen etwa 20nm und etwa 100nm. Die niedermolekulare Löchertransportschicht 26 kann mit einem starken Akzeptormaterial aus niedermolekularen Akzeptormolekülen eines organischen Materials elektrisch dotiert sein. Die Akzeptormoleküle sind in ein organisches Matrixmaterial eingebaut. Die molare Masse der Akzeptormoleküle beträgt zwischen etwa 100g /mol und etwa 200g / mol, bevorzugt zwischen 200g / mol und 1000g / mol. Das Verhältnis zwischen Akzeptormolekülen und Molekülen des organischen Matrixmaterials beträgt zwischen 1 : 1000 und 1 : 2, bevorzugt zwischen 1 : 100 und 1 : 5, weiter bevorzugt zwischen 1 : 100 und 1 : 10.

Eine niedermolekulare organische Schicht 27 aus Akzeptormolekülen eines organischen Materials ist gemäß Fig. 2 auf der niedermolekularen Löchertransportschicht 26 angeordnet. Die Akzeptormoleküle weisen gegenüber Fc / Fc⁺ (Ferrocen / Ferrocenium Redoxpaar) ein Reduktionspotential von wenigstens etwa -0.3V auf. In anderen Ausführungsformen beträgt das Reduktionspotential wenigstens etwa 0V, bevorzugt wenigstens etwa 0.3V. Diese molekulare Eigenschaft korrespondiert mit einem niedrigsten unbesetzten Molekülorbital (LUMO) der Akzeptormoleküle von wenigstens 4.5eV, bevorzugt wenigstens 4.8eV und weiter bevorzugt von wenigstens 5.1eV. Die molare Masse der Akzeptormoleküle beträgt zwischen etwa 100g /mol und etwa 2000g / mol, bevorzugt zwischen etwa 200g / mol und etwa 1000g / mol.

Ein Anodenkontakt 28 ist gemäß Fig. 2 auf der niedermolekularen organischen Schicht 27 aus den Akzeptormolekülen angeordnet. Der Anodenkontakt 28 ist reflektierend für das in dem lichtemittierenden Schichtstapel 20 erzeugte Licht und weist eine Dicke von wenigstens etwa 10nm auf. Als Material für den Anodenkontakt 28 werden Metalle, beispielsweise Au oder Ag, eine Kombination eines Metalls und eines entarteten Halbleitermaterials, zum Beispiel ITO, oder eine Metalllegierung verwendet.

In alternativen Ausführungsformen (nicht dargestellt) des lichtemittierenden Bauelementes 200 können einzelne oder mehrere Schichten weggelassen werden, beispielsweise die polymere Elektroneninjektionsschicht 23, die niedermolekulare löcherseitige Blockschicht 25 und / oder die niedermolekulare Löchertransportschicht 26.

Die in Fig. 2 dargestellte Ausführungsform des lichtemittierenden Bauelementes kann alternativ auch so ausgestaltet werden, daß das in dem lichtemittierenden Schichtstapel 20 erzeugte Licht von dem Substrat 21 weg emittiert wird. Bei dieser Ausführungsform ist der Kathodenkontakt 22 reflektierend, und der Anodenkontakt 28 ist transparent ausgeführt, beispielsweise unter Verwendung eines entarteten Halbleitermaterials. Auch eine transparente Ausgestaltung sowohl des Kathodenkontaktes 22 als auch des Anodenkontaktes 28 kann vorgesehen sein.

Nachfolgend werden Beispiele für verschiedene unter Bezugnahme auf Fig. 2 erläuterte Ausführungsformen näher erläutert.

### Beispiel 5

Bei einem nicht erfinderischem Beispiel 5 weist das lichtemittierende Bauelement den folgenden Aufbau auf, welcher eine niedermolekulare organische Injektionsschicht aus Akzeptormolekülen eines organischen Materials umfasst:
- 5.1: transparentes Substrat (Glas)
- 5.2: Kathodenkontakt (Indium-Zinn Oxid (ITO); 90nm)
- 5.4: polymere elektronentransportierende Emissionsschicht (C8-Polyfluoren (blaue Emission)
- 5.7: niedermolekularer Akzeptormolekül-Schicht (Cl₄DCNQI (N.N'-dicyan-2,3,5,6-tetrachloro-1,4-quinonediimine); 2nm dick)
- 5.8: Anodenkontakt (reflektierend; Ag)

Die gemessene Betriebsspannung betrug etwa 4V. Allerdings konnten mit dem zur Verfügung stehenden polymeren Elektronentransportmaterialien keine gute Elektroneninjektion und kein guter Elektronentransport erreicht werden, weswegen das Potential der niedermolekularer Akzeptormolekül-Schicht nicht vollständig ausgenutzt werden konnte.

### Beispiel 6

Bei einem Beispiel 6 weist das lichtemittierende Bauelement den folgenden Aufbau auf, welcher eine niedermolekulare organische Injektionsschicht aus Akzeptormolekülen eines organischen Materials und eine niedermolekulare organische Injektionsschicht aus Donatormolekülen umfasst:
- 6.1: transparentes Substrat (Glas)
- 6.2: Anodenkontakt (Indium-Zinn Oxid (ITO); 90nm)
- 6.3: niedermolekulare Akzeptormolekül-Schicht (Cl₄DCNQI (N.N'-dicyan-2,3,5,6-tetrachloro-1,4-quinonediimine); 2nm dick)
- 6.4: polymere Löcherinjektionsschicht (PEDOT :PSS (Baytron-P von H. C. Starck, Deutschland); 80nm dick (spin-coated aus wässriger Dispersion)
- 6.5: polymere löchertransportierende Emissionsschicht (MEH-PPV; 70nm dick (spin-coated aus Toluol Lösung)
- 6.6: niedermolekularer Donatormolekül-Schicht (W₂(Xpp)₄; 2nm dick)
- 6.7: Kathodenkontakt (reflektierend; Al)

Im Beispiel 6 ist die Injektionsschicht mit Akzeptormolekülen als optionale Schicht zusätzlich zur polymeren Löcherinjektionsschicht eingebaut.

Die Vorteile der erläuterten Ausführungsformen bestehen darin, dass ein einheitlicher Deckelektrodenkontakt für alle lichtemittierende Polymermaterialien verwendet werden kann, zum Beispiel Polyfluorene, PPVs, Polyspiros, Polythiophene, Polyparaphenylene, also mithin für alle Emissionsfarben. Des weiteren können effizient vom Substrat weg emittierende Bauelemente und transparente Bauelemente hergestellt werden.

Die in der vorstehenden Beschreibung, den Ansprüchen und der Zeichnung offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Lichtemittierendes Bauelement, insbesondere Leuchtdiode, mit einer Anordnung von Schichten auf einem Substrat (1; 21), wobei:
- die Anordnung von Schichten einen Anodenkontakt (2; 28) und einen Kathodenkontakt (22; 8) aufweist,
- der Anodenkontakt (2; 28) und der Kathodenkontakt (22; 8) sind mit einem zwischen dem Anodenkontakt (2; 28) und dem Kathodenkontakt (22; 8) angeordneten, lichtemittierenden Schichtstapel (10; 20) in elektrischem Kontakt,
- der lichtemittierende Schichtstapel (10; 20) umfasst eine niedermolekulare Schicht (7) mit einer Schichtdicke zwischen 0.5nm und 20nm aus im Vakuum aufgebrachten kleinen Molekülen eines organischen, mittels Vakuumverdampfung abscheidbaren Materials, und
- die kleinen Moleküle der niedermolekularen Schicht (7), die benachbart zu dem Kathodenkontakt (8) angeordnet ist, sind gebildet als Donatormoleküle mit einem Oxidationspotential gegenüber Fc / Fc⁺ (Ferrocen / Ferrocenium Redoxpaar) von höchstens etwa -1.5V, und
- der lichtemittierende Schichtstapel (10; 20) umfasst eine polymere Schicht (4; 24) aus einem Polymermaterial,
**dadurch gekennzeichnet, dass** die polymere Schicht (4; 24) eine lichtemitticrcnde und ladungsträgertransportierende Schicht ist.

2. Bauelement nach Anspruch 1, **dadurch gekennzeichnet, dass:**
- der lichtemittierende Schichtstapel eine weitere niedermolekulare Schicht mit einer Schichtdicke zwischen 0.5nm und 20nm aus im Vakuum aufgebrachten kleinen Molekülen eines weiteren organischen, mittels Vakuumverdampfung abscheidbaren Materials, welches von dem organischen Material verschieden ist, umfasst,
- die weitere niedermolekulare Schicht benachbart zu dem Anodenkontakt angeordnet ist und
- die kleinen Moleküle der weiteren niedermolekularen Schicht gebildet sind als Akzeptormoleküle mit einem Reduktionspotential gegenüber Fc / Fc⁺ (Ferrocen / Ferrocenium Redoxpaar) von mindestens etwa -0.3V.

3. Bauelement nach Anspruch 1 oder 2, **dadurch gekennzeichnet, dass** die Donatormoleküle ein Oxidationspotential gegenüber Fc / Fc⁺ (Ferrocen / Ferrocenium Redoxpaar) von höchstens etwa -2.0V, bevorzugt von höchstens etwa -2.2V aufweisen.

4. Bauelement nach Anspruch 2 oder 3, **dadurch gekennzeichnet, dass** die Akzeptormoleküle ein Reduktionspotential gegenüber Fc / Fc⁺ (Ferrocen / Ferrocenium Redoxpaar) von mindestens etwa 0V, bevorzugt von mindestens etwa 0.24V aufweisen.

5. Bauelement nach mindestens einem der vorangehenden Ansprüche, **dadurch gekennzeichnet, dass** die Donatormoleküle und / oder die Akzeptormoleküle eine molare Masse zwischen etwa 100g / mol und etwa 2000g / mol, bevorzugt zwischen etwa 200g / mol und etwa 1000g / mol aufweisen.

6. Bauelement nach mindestens einem der vorangehenden Ansprüche, **dadurch gekennzeichnet, dass** die Donatormoleküle zumindest teilweise als W₂(Xpp)₄-Moleküle (Tetrakis(1,2,3,3a,4,5,6,6a,7,8-Decahydro-1,9,9b-triazaphenalenyl)diwolfram(II)) gebildet sind.

7. Bauelement nach mindestens einem der Ansprüche 2 bis 6, **dadurch gekennzeichnet, dass** die Akzeptormoleküle zumindest teilweise als Cl₄DCNQI-Molekülen (N,N'-dicyano-2,3,5,6-tetrachloro-1,4-quinonediimine) gebildet sind.

8. Bauelement nach mindestens einem der vorangehenden Ansprüche, **dadurch gekennzeichnet, dass** die niedermolekulare und / oder die weitere niedermolekulare Schicht eine Schichtdicke zwischen etwa 1nm und etwa 10nm und bevorzugt zwischen etwa 1nm und etwa 5nm aufweisen.

9. Bauelement nach mindestens einem der vorangehenden Ansprüche, **dadurch gekennzeichnet, dass** die polymere Schicht (4; 24) eine Schichtdicke zwischen etwa 20nm und etwa 500nm, bevorzugt zwischen etwa 40nm und etwa 150nm und weiter bevorzugt zwischen etwa 50nm und etwa 100nm aufweist.

10. Bauelement nach mindestens einem der vorangehenden Ansprüche, **dadurch gekennzeichnet, dass** die polymere Schicht (4; 24) aus einem Polymermaterial ausgewählt aus der folgenden Gruppe von Polymermaterialien ist: Polyfluorene, PPVs, Polyspiros, Polythiophene und Polyparaphenylene.

11. Bauelement nach mindestens einem der vorangehenden Ansprüche, **dadurch gekennzeichnet, dass** zwischen dem Anodenkontakt (2) und der polymeren Schicht (4) eine polymere Löcherinjektionsschicht (3) angeordnet ist.

12. Bauelement nach Anspruch 11, **dadurch gekennzeichnet, dass** die polymere Löcherinjektionsschicht (3) eine Schichtdicke zwischen etwa 20nm und etwa 500nm, bevorzugt zwischen etwa 40nm und etwa 150nm und weiter bevorzugt zwischen etwa 50nm und etwa 100nm aufweist.

13. Bauelement nach mindestens einem der vorangehenden Ansprüche, **dadurch gekennzeichnet, dass** zwischen der niedermolekularen Schicht (7) und der polymeren Schicht (4) eine niedermolekulare organische Elektronentransportschicht (6) angeordnet ist.

14. Bauelement nach Anspruch 13, **dadurch gekennzeichnet, dass** die niedermolekulare organische Elektronentransportschicht (6) ein organisches Matrixmaterial umfasst, welches mit einem niedermolekularen organischen Donatormaterial elektrisch dotiert ist.

15. Bauelement nach Anspruch 14, **dadurch gekennzeichnet, dass** die niedermolekulare organische Elektronentransportschicht (6) eine Dotierungskonzentration (Donatormaterial-Moleküle : Matrixmaterial-Moleküle) zwischen 1 : 1000 und 1 : 2, bevorzugt zwischen 1 : 100 und 1 : 5 und weiter bevorzugt zwischen 1 : 100 und 1 : 10 aufweist.

16. Bauelement nach Anspruch 14 oder 15, **dadurch gekennzeichnet, dass** das organische Donatormaterial eine molare Masse zwischen etwa 100g / mol und etwa 2000g / mol und bevorzugt zwischen etwa 200g / mol und etwa 1000g / mol aufweist.

17. Bauelement nach mindestens einem der Ansprüche 13 bis 16, **dadurch gekennzeichnet, dass** die niedermolekulare organische Elektronentransportschicht (6) eine Schichtdicke zwischen etwa 10nm und etwa 500nm, bevorzugt zwischen etwa 20nm und etwa 200nm und weiter bevorzugt zwischen etwa 20nm und etwa 100nm aufweist.

18. Bauelement nach mindestens einem der Ansprüche 14 bis 17, **dadurch gekennzeichnet, dass** das niedermolekulare organische Donatormaterial W₂(Xpp)₄ ist.

19. Bauelement nach mindestens einem der vorangehenden Ansprüche, **dadurch gekennzeichnet, dass** zwischen der niedermolekularen Schicht (7) und der polymerren Schicht (4) eine niedermolekulare organische Blockschicht (5) angeordnet ist.

20. Bauelement nach Anspruch 19, **dadurch gekennzeichnet, dass** die niedermolekulare organische Blockschicht (5) eine Schichtdicke zwischen etwa 2nm und etwa 50nm, bevorzugt zwischen etwa 2nm und etwa 30nm und weiter bevorzugt zwischen etwa 5nm und etwa 20nm aufweist.

21. Bauelement nach mindestens einem der vorangehenden Ansprüche, **dadurch gekennzeichnet, dass** die Anordnung von Schichten gemäß mindestens einem Aufbau ausgewählt aus der folgenden Gruppe von Aufbauten gebildet ist: invertierter Aufbau; nicht-invertierter Aufbau; Licht, welches in dem lichtemittierenden Schichtstapel erzeugt wird, von dem Substrat weg emittierender Aufbau ("*top-emission*") und Licht, welches in dem lichtemittierenden Schichtstapel erzeugt wird, durch das Substrat emittierender Aufbau ("*bottom-emission*").

22. Bauelement nach mindestens einem der vorangehenden Ansprüche, **dadurch gekennzeichnet, dass** die Anordnung von Schichten mit dem Substrat (1; 21) transparent ist.

23. Bauelement nach mindestens einem der vorangehenden Ansprüche, **gekennzeichnet durch** einen Grundkontakt und einen Deckkontakt, welche mittels des Anodenkontaktcs (2; 28) oder des Kathodenkontaktes (22; 8) gebildet sind und welche aus einem oder mehreren Metallen, einer Kombination eines Metalls und eines entarteten Halbleitematerials oder einer Metalllegierung sind.

## Claims

1. A light-emitting device, in particular a light-emitting diode, with an arrangement of layers on a substrate (1; 21), wherein:
- the arrangement of layers has an anode contact (2; 28) and a cathode contact (22; 8),
- the anode contact (2; 28) and the cathode contact (22; 8) are in electrical contact with a light-emitting layer stack (10; 20) arranged between the anode contact (2; 28) and the cathode contact (22; 8),
- the light-emitting layer stack (10; 20) comprises a low-molecular layer (7) having a layer thickness between 0.5 nm and 20 nm of vacuum-deposited small molecules of an organic material that is separable by means of vacuum evaporation, and
- the small molecules of the low-molecular layer (7) that is arranged adjacent to the cathode contact (8) are formed as donor molecules with an oxidation potential versus Fc / Fc⁺ (ferrocene / ferrocenium redox couple) of maximum approximately -1.5 V, and
- the light-emitting layer stack (10; 20) comprises a polymer layer (4; 24) from a polymer material,
**characterized in that** the polymer layer (4; 24) is a light-emitting and charge carrier transporting layer.

2. The device according to Claim 1, **characterized in that**:
- the light-emitting layer stack comprises a further low-molecular layer having a layer thickness between 0.5 nm and 20 nm of vacuum-deposited small molecules of a further organic material that is separable by means of vacuum evaporation which is different from the organic material,
- the further low-molecular layer is arranged adjacent to the anode contact, and
- the small molecules of the further low-molecular layer are formed as acceptor molecules with a reduction potential versus Fc / Fc⁺ (ferrocene / ferrocenium redox couple) of minimum approximately -0.3 V.

3. The device according to Claim 1 or 2, **characterized in that** the donor molecules have an oxidation potential versus Fc / Fc⁺ (ferrocene / ferrocenium redox couple) of maximum approximately -2.0 V, preferably of maximum approximately -2.2 V.

4. The device according to Claim 2 or 3, **characterized in that** the acceptor molecules have a reduction potential versus Fc / Fc⁺ (ferrocene / ferrocenium redox couple) of minimum approximately 0 V, preferably of minimum approximately 0.24 V.

5. The device according to at least any one of the preceding claims, **characterized in that** the donor molecules and/or the acceptor molecules have a molar mass between approximately 100 g/mol and approximately 2000 g/mol, preferably between approximately 200 g/mol and approximately 1000 g/mol.

6. The device according to at least any one of the preceding claims, **characterized in that** the donor molecules are formed at least partially as W₂(Xpp)₄-molecules (Tetrakis(1,2,3,3a,4,5,6,6a,7,8-decahydro-1,9,9b-triazaphenalenyl)ditungsten(II).

7. The device according to at least any one of the claims 2 to 6, **characterized in that** the acceptor molecules are at least partially formed as Cl₄DCNQI-molecules (N,N'-dicyano-2,3,5,6-tetrachloro-1,4-quinonediimine).

8. The device according to at least any one of the preceding claims, **characterized in that** the low-molecular and/or the further low-molecular layer have a layer thickness between approximately 1 nm and approximately 10 nm and preferably between approximately 1 nm and approximately 5 nm.

9. The device according to at least any one of the preceding claims, **characterized in that** the polymer layer (4; 24) has a layer thickness between approximately 20 nm and approximately 500 nm, preferably between approximately 40 nm and approximately 150 nm and more preferably between approximately 50 nm and approximately 100 nm.

10. The device according to at least any one of the preceding claims, **characterized in that** the polymer layer (4; 24) is from a polymer material selected from the following group of polymer materials: polyfluorenes, PPVs, polyspiros, polythiophenes and polyparaphenylenes.

11. The device according to at least any one of the preceding claims, **characterized in that** a polymer hole injection layer (3) is arranged between the anode contact (2) and the polymer layer (4).

12. The device according to Claim 11, **characterized in that** the polymer hole injection layer (3) has a layer thickness between approximately 20 nm and approximately 500 nm, preferably between approximately 40 nm and approximately 150 nm and more preferably between approximately 50 nm and approximately 100 nm.

13. The device according to at least any one of the preceding claims, **characterized in that** a low-molecular organic electron transport layer (6) is arranged between the low-molecular layer (7) and the polymer layer (4).

14. The device according to Claim 13, **characterized in that** the low-molecular organic electron transport layer (6) comprises an organic matrix material which is electrically doped with a low-molecular organic donor material.

15. The device according to Claim 14, **characterized in that** the low-molecular organic electron transport layer (6) has a doping concentration (donor material molecules : matrix material molecules) between 1 : 1000 and 1 : 2, preferably between 1 : 100 and 1 : 5 and more preferably between 1 : 100 and 1 : 10.

16. The device according to Claim 14 or 15, **characterized in that** the organic donor material has a molar mass between approximately 100 g/mol and approximately 2000 g/mol and preferably between approximately 200 g/mol and approximately 1000 g/mol.

17. The device according to at least any one of the Claims 13 to 16, **characterized in that** the low-molecular organic electron transport layer (6) has a layer thickness between approximately 10 nm and approximately 500 nm, preferably between approximately 20 nm and approximately 200 nm and more preferably between approximately 20 nm and approximately 100 nm.

18. The device according to at least any one of the Claims 14 to 17, **characterized in that** the low-molecular organic donor material is W₂(Xpp)₄.

19. The device according to at least any one of the preceding claims, **characterized in that** a low-molecular organic blocking layer (5) is arranged between the low-molecular layer (7) and the polymer layer (4).

20. The device according to Claim 19, **characterized in that** the low-molecular organic blocking layer (5) has a layer thickness between approximately 2 nm and approximately 50 nm, preferably between approximately 2 nm and approximately 30 nm and more preferably between approximately 5 nm and approximately 20 nm.

21. The device according to at least any one of the preceding claims, **characterized in that** the arrangement of layers is formed according to at least one configuration selected from the following group of configurations: inverted configuration; noninverted configuration; configuration having light which is generated in the light-emitting layer stack emitting away from the substrate ("top-emission"), and configuration having light which is generated in the light-emitting layer stack emitting through the substrate ("bottom-emission").

22. The device according to at least any one of the preceding claims, **characterized in that** the arrangement of layers with the substrate (1; 21) is transparent.

23. The device according to at least any one of the preceding claims, **characterized by** a bottom contact and a top contact which are formed by means of the anode contact (2; 28) or the cathode contact (22; 8) and which are from one or several metals, a combination of a metal and a degenerate semiconductor material or a metal alloy.

## Revendications

1. Composant électroluminescent, en particulier diode électroluminescente, avec un arrangement de couches sur un substrat (1 ; 21), étant donné que :
- l'arrangement de couches présente un contact d'anodes (2 ; 28) et un contact de cathodes (22 ; 8),
- le contact d'anodes (2 ; 28) et le contact de cathodes (22 ; 8) sont en contact électrique avec une pile de couches électroluminescente (10 ; 20) disposée entre le contact d'anodes (2 ; 28) et le contact de cathodes (22 ; 8),
- la pile de couches électroluminescente (10 ; 20) comprend une couche à poids moléculaire bas (7) avec une épaisseur de couche entre 0,5 nm et 20 nm composée de petites molécules d'un matériau organique appliqué sous vide et séparable par évaporation sous vide, et
- les petites molécules de la couche à poids moléculaire bas (7) qui est disposée dans le voisinage du contact de cathodes (8) sont formée comme molécules donatrices avec un potentiel d'oxydation par rapport à Fc / Fc⁺ (paire redox Ferrocen / Ferrocenium) d'environ -1,5 V au maximum, et
- la pile de couches électroluminescente (10 ; 20) comprend une couche polymère (4 ; 24) en un matériau polymère,
**caractérisé en ce que** la couche polymère (4 ; 24) est une couche électroluminescente et de transport de porteurs de charge.

2. Composant selon la revendication 1, **caractérisé en ce que**
- la pile de couches électroluminescente comprend une autre couche à poids moléculaire bas avec une épaisseur de couche entre 0,5 nm et 20 nm composée de petites molécules d'un autre matériau organique appliqué sous vide et séparable par évaporation sous vide, matériau différent dudit matériau organique,
- l'autre couche à poids moléculaire bas est disposée dans le voisinage du contact d'anodes, et
- les petites molécules de l'autre couche à poids moléculaire bas sont formées comme molécules acceptrices avec un potentiel de réduction par rapport à Fc / Fc⁺ (paire redox Ferrocen / Ferrocenium) d'environ -0,3 V au maximum.

3. Composant selon la revendication 1 ou 2, **caractérisé en ce que** les molécules donatrices présentent un potentiel d'oxydation par rapport à Fc / Fc⁺ (paire redox Forrocen / Ferrocenium) d'environ -2,0 V au maximum, de préférence d'environ -2,2 V au maximum.

4. Composant selon la revendication 2 ou 3, **caractérisé en ce que** les molécules acceptrices présentent un potentiel de réduction par rapport à Fc / Fc⁺ (paire redox Forrocen / Ferrocenium) d'environ 0V au moins, de préférence d'environ 0,24V au moins.

5. Composant selon au moins l'une quelconque des revendications précédentes, **caractérisé en ce que** les molécules donatrices et/ou les molécules acceptrices présentent une masse molaire entre environ 100 g/mol et environ 2000 g/mol, de préférence entre environ 200 g/mol et environ 1000 g/mol.

6. Composant selon au moins l'une quelconque des revendications précédentes, **caractérisé en ce que** les molécules donatrices sont formée au moins partiellement comme molécules W₂(Xpp)₄ (Tetrakis(1,2,3,3a,4,5,6,6a,7,8-Décahydro-1,9,9b-triazaphenalenyl)diwolfram(II)).

7. Composant selon au moins l'une quelconque des revendications 2 à 6, **caractérisé en ce que** les molécules acceptrices sont formées au moins partiellement comme molécules CI₄DCNQI (N,N'-dicyano-2,3,5,6-tétrachloro-1,4-quinonediimine).

8. Composant selon au moins l'une quelconque des revendications précédentes, **caractérisé en ce que** la couche à poids moléculaire bas et/ou l'autre couche à poids moléculaire bas présentent une épaisseur de couche entre environ 1 nm et environ 10 nm et de préférence entre environ 1 nm et environ 5 nm.

9. Composant selon au moins l'une quelconque des revendications précédentes, **caractérisé en ce que** la couche polymère (4 ; 24) présente une épaisseur de couche entre environ 20 nm et environ 500 nm, de préférence entre environ 40 nm et environ 150 nm et encore plus préféré entre environ 50 nm et environ 100 nm.

10. Composant selon au moins l'une quelconque des revendications précédentes, **caractérisé en ce que** la couche polymère (4 ; 24) est en un matériau polymère sélectionnée dans le groupe de matériaux polymères suivant : polyfluorènes, PPV, polyspiros, polythiophènes et polyparaphénylènes.

11. Composant selon au moins l'une quelconque des revendications précédentes, **caractérisé en ce qu'**est disposée entre le contact d'anode (2) et la couche polymère (4) une couche d'injection à trous polymère (3).

12. Composant selon la revendication 11, **caractérisé en ce que** la couche d'injection à trous polymère (3) présente une épaisseur de couche entre environ 20 nm et environ 500 nm, de préférence entre environ 40 nm et environ 150 nm et encore plus préféré entre environ 50 nm et environ 100 nm.

13. Composant selon au moins l'une quelconque des revendications précédentes, **caractérisé en ce qu'**est disposée entre la couche à poids moléculaire bas (7) et la couche polymère (4) une couche de transport d'électrons organique à poids moléculaire bas (6).

14. Composant selon la revendication 13, **caractérisé en ce que** la couche de transport d'électrons organique à poids moléculaire bas (6) comprend un matériau de matrice organique qui est dopé électriquement avec un matériau donateur organique à poids moléculaire bas.

15. Composant selon la revendication 14, **caractérisé en ce que** la couche de transport d'électrons organique à poids moléculaire bas (6) présente une concentration de dopage (molécules de matériau donateur : molécules de matériau de matrice) située entre 1 : 1000 et 1 : 2, de préférence entre 1 : 100 et 1 : 5 et encore plus préféré entre 1 : 100 et 1 : 10.

16. Composant selon la revendication 14 ou 15, **caractérisé en ce que** le matériau donateur organique présente une masse molaire entre environ 100 g/mol et environ 2000 g/mol, et de préférence entre environ 200 g/mol et environ 1000 g/mol.

17. Composant selon au moins l'une quelconque des revendications 13 à 16, **caractérisé en ce que** la couche de transport d'électrons organique à poids moléculaire bas (6) présente une épaisseur de couche entre environ 10 nm et environ 500 nm, de préférence entre environ 20 nm et environ 200 nm et encore plus préféré entre environ 20 nm et environ 100 nm.

18. Composant selon au moins l'une quelconque des revendications 14 à 17, **caractérisé en ce que** le matériau donateur organique à poids moléculaire bas est W₂(Xpp)₄.

19. Composant selon au moins l'une quelconque des revendications précédentes, **caractérisé en ce qu'**est disposée entre la couche à poids moléculaire bas (7) et la couche polymère (4) une couche de blocage organique à poids moléculaire bas (5).

20. Composant selon la revendication 19, **caractérisé en ce que** la couche de blocage organique à poids moléculaire bas (5) présente une épaisseur de couche entre environ 2 nm et environ 50 nm, de préférence entre environ 2 nm et environ 30 nm et encore plus préféré entre environ 5 nm et environ 20 nm.

21. Composant selon au moins l'une quelconque des revendications précédentes, **caractérisé en ce que** l'arrangement de couches est formé conformément à au moins une structure sélectionnée dans le groupe de structures suivant : structure inverse ; structure non inverse ; lumière générée dans la pile de couches électroluminescente, structure émettant à partir du substrat (*« top emission »*) et lumière générée dans la pile de couches électroluminescente, structure émettant à travers le substrat (*« bottom emission »*).

22. Composant selon au moins l'une quelconque des revendications précédentes, **caractérisé en ce que** l'arrangement de couches avec le substrat (1 ; 21) est transparent.

23. Composant selon au moins l'une quelconque des revendications précédentes, **caractérisé par** un contact de base et un contact couvrant qui sont formés au moyen du contact d'anodes (2 ; 28) ou du contact de cathodes (22 ; 8) et qui sont constitués d'un ou de plusieurs métaux, d'une combinaison d'un métal et d'un matériau semi-conducteur dégénéré ou d'un alliage de métaux.
